Europäisches Patentamt

European Patent Office

Office européen des brevets

(19)

(11) EP 0 922 963 A2

(12) EUROPÄISCHE PATENTANMELDUNG

(43) Veröffentlichungstag:
16.06.1999 Patentblatt 1999/24

(51) Int. Cl.⁶: G01R 27/26

(21) Anmeldenummer: 98119587.8

(22) Anmeldetag: 16.10.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 12.12.1997 DE 19755417

(71) Anmelder:
FRAUNHOFER-GESELLSCHAFT ZUR
FÖRDERUNG DER
ANGEWANDTEN FORSCHUNG E.V.
80636 München (DE)

(72) Erfinder:
• Hillerich, Bernd
  89075 Ulm (DE)
• Leidl, Anton
  81739 München (DE)
• Härle, Thomas
  86157 Augsburg (DE)

(54) Auswerteschaltung zur Ermittlung komplexer Impedanzen, Vorrichtung zur Messung komplexer Impedanzen und Verwendung der Vorrichtung

(57) Die vorliegende Erfindung bezieht sich auf eine Auswerteschaltung zur Ermittlung komplexer Impedanzen sowie auf eine Vorrichtung zur Messung komplexer Impedanzen mit dieser Auswerteschaltung. Die erfindungsgemäße Vorrichtung zur Messung komplexer Impedanzen kann vorteilhafterweise zur Analyse der Eigenschaften von Flüssigkeiten, zur Bestimmung des Alterungszustands von Schmierölen, zur Feuchtemessung in Erdböden, zur Messung von Ionenkonzentrationen, zur Bestimmung des Wassergehalts in Flüssigkeiten mit niedriger Dielektrizitätszahl, insbesondere aber zur Bestimmung der Wasserkonzentration in Alkoholen und umgekehrt, zur Bestimmung des Wassergehalts in Ölen und umgekehrt, zur Bestimmung des Wassergehalts in Bremsflüssigkeit, zur Bestimmung der Zusammensetzung von Milch, insbesondere zur Bestimmung ihres Fettgehalts, zur Bestimmung des Zeitpunkts der Aushärtung von Beton und zur Untersuchung der Verunreinigung des Erdbodens mit Öl oder Säuren verwendet werden. Insbesondere, wenn die Vorrichtung als Sensor einen Oberflächenwellen-Sensor enthält, können mit der erfindungsgemäßen Vorrichtung Säuren und Laugen in Wasser identifiziert und ihre Konzentrationsbestimmung vorgenommen werden.

Die erfindungsgemäße Auswerteschaltung zur Ermittlung komplexer Impedanzen umfaßt eine Spannungsquelle zur Erzeugung zweier Wechselspannungssignale mit einer ersten Frequenz, eine Stromquelle, die von dem ersten von den zwei Wechselspannungssignalen angesteuert wird und geeignet ist, ein Wechselstromsignal zu erzeugen, eine Verstärkungseinrichtung, der das über die zu messende Impedanz abfallende Signal zugeführt wird und die geeignet ist, ein entsprechende Wechselspannungssignal zu erzeugen, eine Einrichtung, die geeignet ist, das von der Verstärkungseinrichtung ausgegebene Wechselspannungssignal mit dem zweiten von den zwei Wechselspannungssignalen von der Spannungsquelle, welches jeweils um 0° oder 90° phasenverschoben ist, dergestalt zu kombinieren, daß aus den sich jeweils ergebenden ersten und zweiten Ausgangssignalen der Realteil und der Imaginärteil der Impedanz ermittelbar ist, eine Einrichtung zur Verarbeitung des ersten und zweiten Ausgangssignals, wobei der Realteil und der Imaginärteil der komplexen Impedanz ermittelt wird, wobei die Spannungsquelle einen Frequenzgenerator zur Erzeugung von Digitalsignalen, einen 1:2-Frequenzteiler und eine Vorrichtung zur Erzeugung zweier um 90° phasenverschobener Wechselspannungssignale mit der ersten Frequenz umfaßt.

Die erfindungsgemäße Auswerteschaltung ermöglicht eine genaue Ermittlung der komplexen Impedanzen selbst bei Temperaturschwankungen oder verschiedenen Meßfrequenzen ohne die Notwendigkeit komplexer Vorrichtungen zum Phasenabgleich.

EP 0 922 963 A2

**Beschreibung**

Die vorliegende Erfindung bezieht sich auf eine Auswerteschaltung zur Ermittlung komplexer Impedanzen sowie auf eine Vorrichtung zur Messung komplexer Impedanzen mit dieser Auswerteschaltung. Die erfindungsgemäße Vorrichtung zur Messung komplexer Impedanzen kann vorteilhafterweise zur Analyse der Eigenschaften von Flüssigkeiten, zur Bestimmung des Alterungszustands von Schmierölen, zur Feuchtemessung in Erdböden, zur Messung von Ionenkonzentrationen, zur Bestimmung des Wassergehalts in Flüssigkeiten mit niedriger Dielektrizitätszahl, insbesondere aber zur Bestimmung der Wasserkonzentration in Alkoholen und umgekehrt, d.h. zur Bestimmung der Alkoholkonzentration in Wasser, zur Bestimmung des Wassergehalts in Ölen und umgekehrt, zur Bestimmung des Wassergehalts in Bremsflüssigkeit, zur Bestimmung der Zusammensetzung von Milch, insbesondere zur Bestimmung ihres Fettgehalts, zur Bestimmung des Zeitpunkts der Aushärtung von Beton und zur Untersuchung der Verunreinigung des Erdbodens mit Öl oder Säuren verwendet werden. Insbesondere, wenn die Vorrichtung als Sensor einen Oberflächenwellen-Sensor enthält, können mit der erfindungsgemäßen Vorrichtung Säuren und Laugen in Wasser identifiziert und ihre Konzentrationsbestimmung vorgenommen werden.

Die Messung der dielektrischen Eigenschaften (Dielektrizitätszahl und Leitfähigkeit) von festen und flüssigen Materialien wird allgemein eingesetzt, um die Qualität von Materialien zu charakterisieren oder Veränderungen, beispielsweise in ihrer Zusammensetzung festzustellen. Beispielhafte Anwendungen sind Feuchtemessungen in Gasen oder festen Medien, die Messung von Ionenkonzentrationen oder die Bestimmung des Wassergehalts von Flüssigkeiten mit niedriger Dielektrizitätszahl (z. B. Alkohol, Öl, Bremsflüssigkeit beim Kraftfahrzeug).

In den bekannten Vorrichtungen zur Messung der komplexen Impedanz ist der Sensor in der Regel eine aus mindestens zwei Elektroden bestehende Kapazität, die als Plattenkondensator, in Form koaxialer Röhren oder als flächig angeordneter Interdigitalkondensator (IDK) realisiert ist. Gemessen wird die komplexe Impedanz $Z = 1/j\omega C + R$, wobei $\omega$ die Kreisfrequenz, $j = \sqrt{-1}$, C die Kapazität und R den Widerstand bezeichnet.

Als Auswerteschaltungen für derartige Vorrichtungen sind einerseits Oszillatorschaltungen bekannt, bei denen die Kapazität C des Sensors die Schwingfrequenz und der Widerstand R die Schwingamplitude beeinflußt. Nachteile dieser Auswerteschaltung sind der eingeschränkte Meßbereich und die geringe Meßgenauigkeit für die Leitfähigkeit, falls R wesentlich größer als $1/\omega C$ ist. In der Regel funktioniert diese Auswerteschaltung nicht, falls R nicht um einen bestimmten Faktor größer als $1/\omega C$ ist, da dann der Oszillator nicht anschwingt.

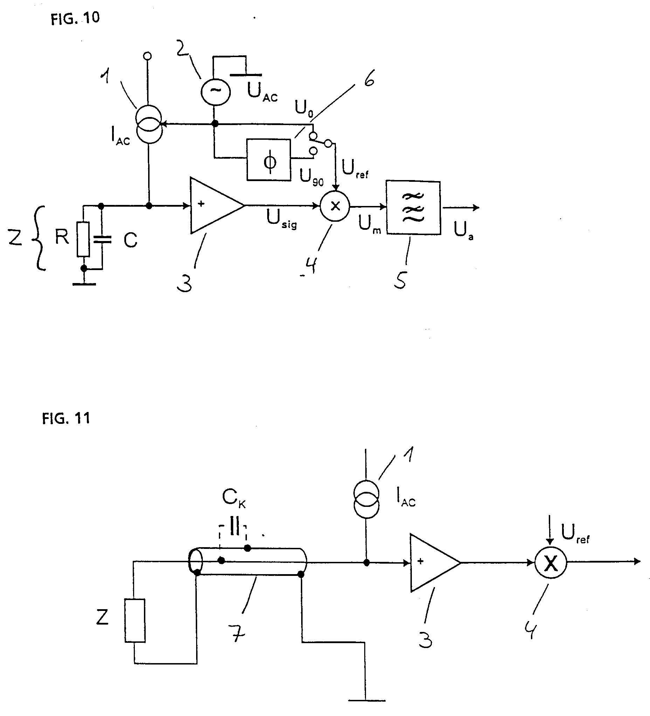

Andererseits ist eine bekannte Auswerteschaltung zur Ermittlung komplexer Impedanzen mit den Merkmalen des Oberbegriffs von Anspruch 1 wie in Fig. 10 gezeigt aufgebaut. Eine solche Auswerteschaltung ist beispielsweise aus dem Aufsatz „A broad-bandwidth mixed analog/digital integrated circuit for the measurement of complex impedances" von M.A. Hilhorst et al., IEEE Journal of solid state circuits, vol. 28, No. 7, S. 764 ff. (1993) bekannt.

Bei der in Fig. 10 gezeigten Anordnung ist die Größe der Wechselspannung, die über der Meßimpedanz Z, die in Fig. 10 als Parallelschaltung der Kapazität C und dem Widerstand R dargestellt ist, abfällt, proportional zur Impedanz selbst. Dies wird beispielsweise dadurch erreicht, daß in die Impedanz ein Wechselstrom $I_{AC}$ eingeprägt wird, indem eine spannungsgesteuerte Stromquelle 1 von einer Wechselspannungsquelle 2 angesteuert wird. Das über der Impedanz Z abfallende Wechselspannungssignal gelangt über einen Verstärker 3 auf einen Multiplizierer oder Mischer 4, wobei das zweite Eingangssignal $U_{ref}$ entweder mit der Phasenverschiebung $\phi=0°$ oder $\phi=90°$, bezogen auf $U_{AC}$, dem Multiplizierer zugeführt wird.

Bei der in Fig. 10 gezeigten Anordnung wird die Phasenverschiebung $\phi=90°$ durch einen Phasenschieber 6 bewirkt. Im ersten Fall ($\phi=0°$) handelt es sich um eine In-Phase-Demodulation, d.h. das Ausgangssignal des Multiplizierers hat die Form $U_M = U_{sig} \times U_{ref}$. Der am Ausgang des Tiefpaßfilters 5 vorliegende Mittelwert von $U_M$ ist dann also proportional zum Realteil der Impedanz Z. Im zweiten Fall ($\phi=90°$) handelt es sich um eine Quadraturdemodulation, und das Ausgangssignal $U_a$ ist proportional zum Imaginärteil der Impedanz.

Dieses Verfahren ermöglicht somit eine in weiten Bereichen korrekte Bestimmung von Real- und Imaginärteil der Impedanz, bzw. ihrem Kehrwert, also von Leitwert und Kapazität.

Mit diesem bekannten Verfahren ist jedoch das Problem verbunden, daß die Meßgenauigkeit des Imaginärteils stark dadurch beeinflußt wird, wie genau die Phasenverschiebung $\phi = 90°$ eingehalten wird. In der Regel ist ein Abgleich erforderlich, der zusätzliche Herstellungskosten verursacht.

Darüber hinaus treten bei Schwankungen der Umgebungstemperatur in der Regel auch Schwankungen des Phasenwinkels und damit Meßungenauigkeiten auf. Des weiteren muß bei den vorstehend geschilderten Anwendungen des Meßverfahrens häufig bei mehreren Frequenzen gemessen werden. In diesem Fall ist die Notwendigkeit eines Phasenabgleichs besonders ungünstig bzw. führt zu erhöhtem Aufwand.

Der vorliegenden Erfindung liegt somit die Aufgabe zugrunde, die bekannte Auswerteschaltung zur Ermittlung komplexer Impedanzen dergestalt weiterzubilden, daß in der erfindungsgemäßen Auswerteschaltung selbst bei Temperaturschwankungen oder verschiedenen Meßfrequenzen eine konstante Phasenverschiebung von φ=90° ohne Notwendigkeit komplexer Vorrichtungen zum Phasenabgleich aufrecht erhalten werden kann.

Gemäß der vorliegenden Erfindung wird die Aufgabe durch die kennzeichnenden Merkmale des Anspruchs 1 gelöst. Gemäß der vorliegenden Erfindung wird weiterhin die Vorrichtung nach Anspruch 10 sowie die Verwendung der erfindungsgemäßen Vorrichtung nach einem der Ansprüche 18 bis 30 bereitgestellt.

Die bevorzugten Ausführungsformen sind Gegenstand der Unteransprüche.

Die vorliegende Erfindung betrifft somit eine Auswerteschaltung zur Ermittlung komplexer Impedanzen mit einer Spannungsquelle zur Erzeugung zweier Wechselspannungssignale mit einer ersten Frequenz, einer Stromquelle oder einem hochohmigen Widerstand, die oder der von dem ersten von den zwei Wechselspannungssignalen angesteuert wird und geeignet ist, ein Wechselstromsignal zu erzeugen, einer Verstärkungseinrichtung, der das über die zu messende Impedanz abfallende Signal zugeführt wird und die geeignet ist, ein entsprechende Wechselspannungssignal zu erzeugen, einer Einrichtung, die geeignet ist, das von der Verstärkungseinrichtung ausgegebene Wechselspannungssignal mit dem zweiten von den zwei Wechselspannungssignalen von der Spannungsquelle, welches jeweils um 0° oder 90° phasenverschoben ist, dergestalt zu kombinieren, daß aus den sich jeweils ergebenden ersten und zweiten Ausgangssignalen der Realteil und der Imaginärteil der Impedanz ermittelbar ist, einer Einrichtung zur Verarbeitung des ersten und zweiten Ausgangssignals, wobei der Realteil und der Imaginärteil der komplexen Impedanz ermittelt wird, wobei die Spannungsquelle einen Frequenzgenerator zur Erzeugung von Digitalsignalen, einen 1:2-Frequenzteiler und eine Vorrichtung zur Erzeugung zweier um 90° phasenverschobener Wechselspannungssignale mit der ersten Frequenz umfaßt, wobei die Phasenverschiebung bei Variation der Frequenz erhalten bleibt.

Dadurch, daß im Gegensatz zur bekannten Vorrichtung die Phasenverschiebung nicht durch einen Phasenschieber eingestellt wird, sondern die Spannungsquelle einen Frequenzgenerator zur Erzeugung von Digitalsignalen, einen 1:2-Frequenzteiler und eine Vorrichtung zur Erzeugung zweier um 90° phasenverschobener Wechselspannungssignale mit der ersten Frequenz umfaßt, wobei die Phasenversschiebung bei Variation der Frequenz erhalten bleibt, lassen sich in einem großen Frequenzbereich, der nur von der Grenzfrequenz der verwendeten Logikbausteine bestimmt ist, zwei um 90° phasenverschobene Signale erzeugen, ohne daß ein Abgleich erforderlich ist.

Dabei ist der Frequenzgenerator vorzugsweise geeignet, ein Signal mit der doppelten Meßfrequenz und einem Tastverhältnis von 50 % zu erzeugen. Alternativ kann, wenn der Frequenzgenerator kein Digitalsignal mit exakt diesem Tastverhältnis erzeugt, der Frequenzgenerator ein Signal mit der vierfachen Meßfrequenz erzeugen, und die Spannungsquelle umfaßt ferner einen zweiten 1:2-Frequenzteiler.

Gemäß einer bevorzugten Ausführungsform ist die Vorrichtung zur Erzeugung zweier um 90° phasenverschobener Wechselspannungssignale mit der ersten Frequenz ein D-Flip-Flop.

Weiterhin betrifft die vorliegende Erfindung eine Vorrichtung zur Messung komplexer Impedanzen mit einem oder mehreren Sensoren zur Erfassung der komplexen Impedanz, und einer Auswerteschaltung wie vorstehend definiert.

Gemäß der vorliegenden Erfindung kann die erfindungsgemäße Vorrichtung zur Messung komplexer Impedanzen vorteilhafterweise zur Analyse der Eigenschaften von Flüssigkeiten, zur Bestimmung des Alterungszustands von Schmierölen, zur Feuchtemessung in Erdböden, zur Messung von Ionenkonzentrationen, zur Bestimmung des Wassergehalts in Flüssigkeiten mit niedriger Dielektrizitätszahl, insbesondere aber zur Bestimmung der Wasserkonzentration in Alkoholen und umgekehrt, zur Bestimmung des Wassergehalts in Ölen und umgekehrt, zur Bestimmung des Wassergehalts in Bremsflüssigkeit, zur Bestimmung der Zusammensetzung von Milch, insbesondere zur Bestimmung ihres Fettgehalts, zur Bestimmung des Zeitpunkts der Aushärtung von Beton und zur Untersuchung der Verunreinigung des Erdbodens mit Öl oder Säuren verwendet werden. Insbesondere, wenn die Vorrichtung als Sensor einen Oberflächenwellen-Sensor enthält, kann mit der erfindungsgemäßen Vorrichtung die Identifikation von Säuren und Laugen in Wasser und ihre Konzentrationsbestimmung vorgenommen werden.

Im folgenden wird die vorliegende Erfindung unter Bezugnahme auf die begleitenden Zeichnungen detaillierter beschrieben werden.

In den begleitenden Zeichnungen

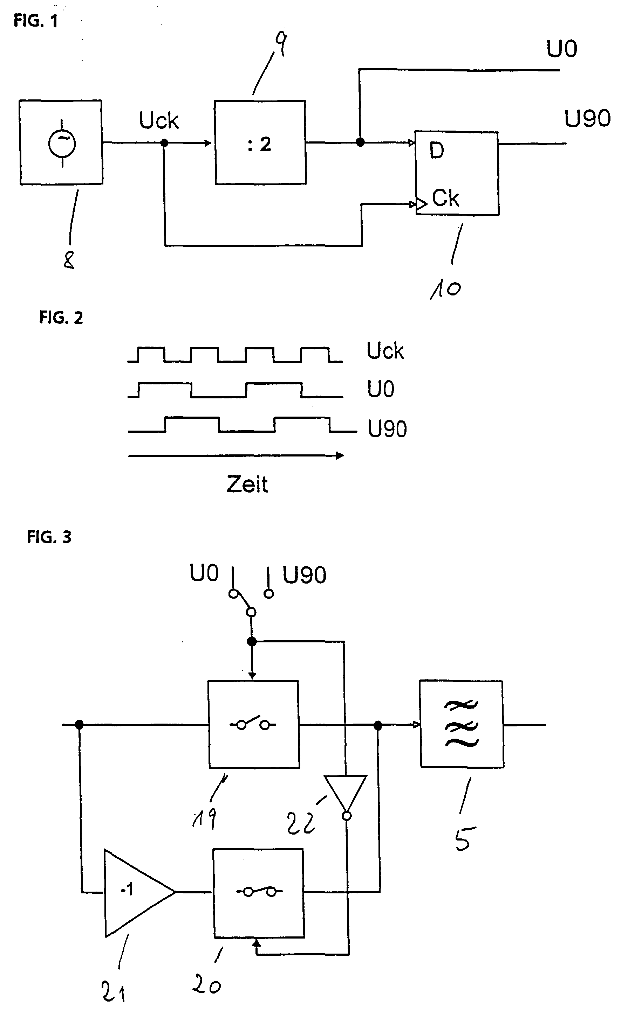

zeigt Fig. 1 die relevanten Komponenten der Spannungsquelle bei der erfindungsgemäßen Auswerteschaltung;

zeigt Fig. 2 die durch die relevanten Komponenten der Spannungsquelle erzeugten Signalformen;

zeigt Fig. 3 eine Einrichtung, die anstelle des Multiplizierers oder Mischers zur geeigneten Kombination der jeweiligen Signale verwendet werden kann;

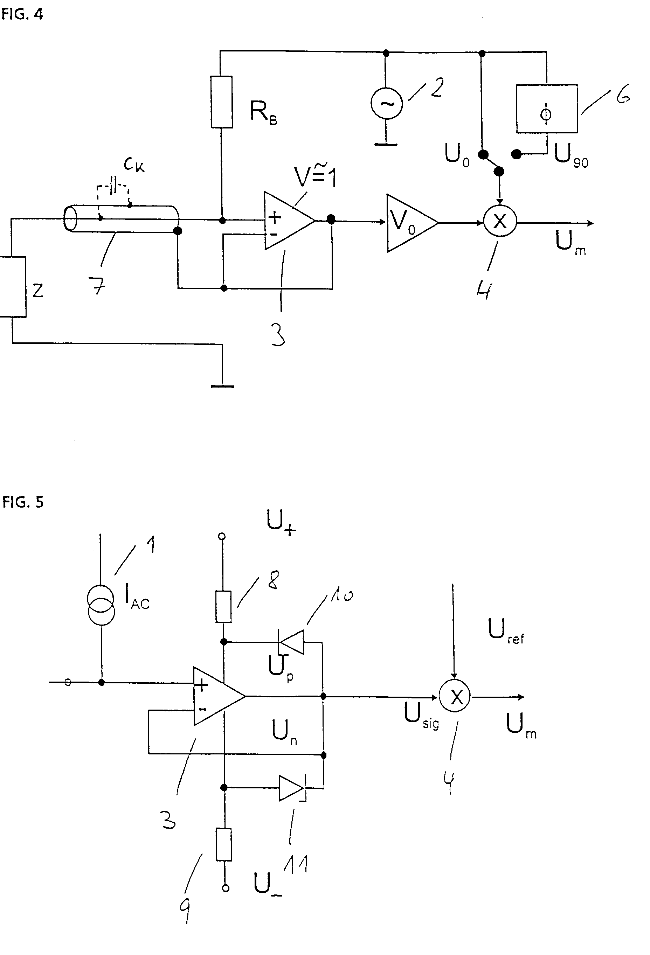

zeigt Fig. 4 eine weitere bevorzugte Ausführungsform der vorliegenden Erfindung;

zeigt Fig. 5 noch eine weitere bevorzugte Ausführungsform der vorliegenden Erfindung;

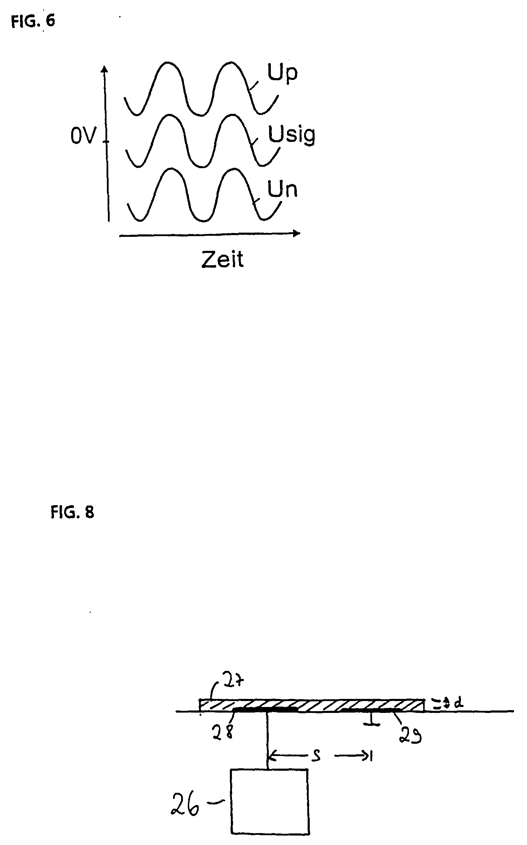

zeigt Fig. 6 die bei der in Fig. 5 gezeigten Ausführungsform erzeugten Signalformen;

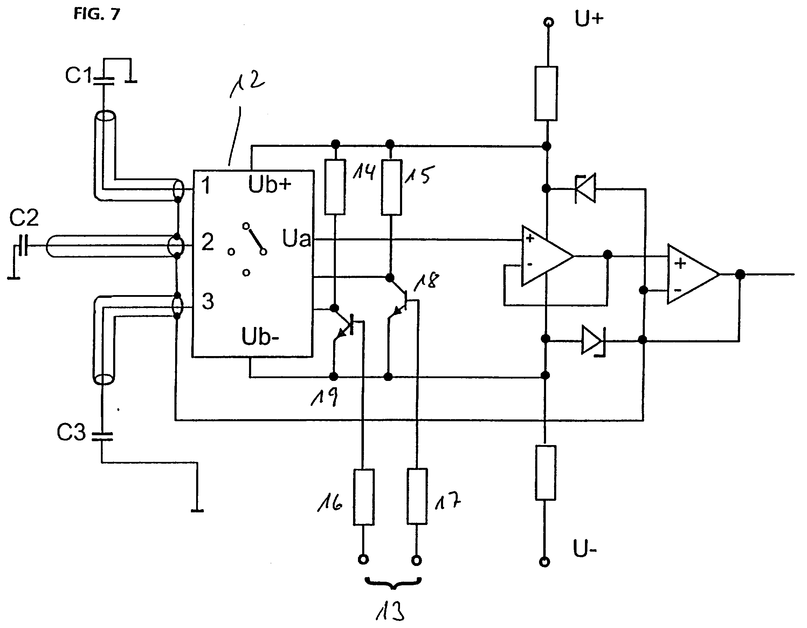

zeigt Fig. 7 eine weitere bevorzugte Ausführungsform der vorliegenden Erfindung;

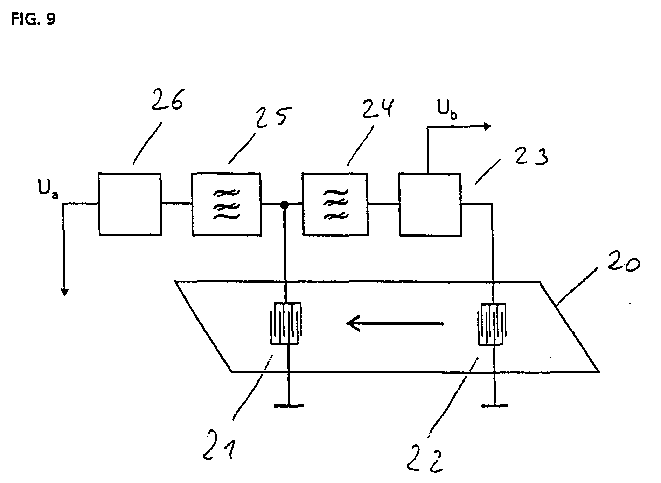

zeigt Fig. 8 eine beispielhafte Elektrodenanordnung bei dem Sensor der erfindungsgemäßen Vorrichtung;

zeigt Fig. 9 eine weitere beispielhafte Ausgestaltung der Elektroden bei dem Sensor der erfindungsgemäßen Vorrichtung;

zeigt Fig. 10 eine bekannte Vorrichtung zur Messung komplexer Impedanzen; und

illustriert Fig. 11 den Einfluß der Kapazität des geschirmten Kabels bei der in Fig. 10 gezeigten Vorrichtung.

In Fig. 1 bezeichnet Bezugszeichen 8 einen Frequenzgenerator, Bezugszeichen 9 bezeichnet einen Frequenzteiler, der eine eingegegebene Frequenz durch 2 teilt, und Bezugszeichen 10 bezeichnet eine Vorrichtung zur Erzeugung zweier um 90° phasenverschobener Wechselspannungssignale umfaßt. Bei der vorliegenden Ausführungsform ist die Vorrichtung 10 durch ein D-Flip-Flop realisiert.

Ausgehend von der doppelten Meßfrequenz, die durch den Frequenzgenerator 8 als Digitalsignal $U_{ck}$ erzeigt wird, werden mit dem Frequenzteiler 9 und dem D-Flip-Flop 10 zwei um 90° phasenverschobene Signale erzeugt, wie in Fig. 2 gezeigt ist. Der Phasenwinkel ist exakt 90°, wenn das Tastverhältnis von $U_{ck}$ exakt 50% beträgt. Erzeugt der Frequenzgenerator 8 das Digitalsignal nicht exakt mit diesem Tastverhältnis, so läßt es sich aus der vierfachen Meßfrequenz unter Einsatz eines weiteren 1:2-Frequenzteilers erzeugen.

Die beiden Signale $U_0$ und $U_{90}$ dienen zur Ansteuerung des Multiplizierers 4, der in Fig. 10 gezeigt ist, eines der beiden Signale wird zur Ansteuerung der spannungsgesteuerten Stromquelle 1 verwendet. In diesem Fall wird die Stromquelle durch ein Rechtecksignal angesteuert, was zur Folge hat, daß die Impedanzmessung nicht nur bei der Meßfrequenz sondern auch bei ihren Harmonischen erfolgt. Wenn dies störend ist, erfolgt die Unterdrückung der höheren Harmonischen durch ein Tiefpaßfilter zwischen den Signalen $U_0$ bzw. $U_{90}$ und dem Steuereingang der Stromquelle. Mit diesem Verfahren lassen sich in einem großen Frequenzbereich, der nur von der Grenzfrequenz der verwendeten Logikbausteine bestimmt ist, zwei um 90° phasenverschobene Signale erzeugen, ohne daß ein Abgleich erforderlich ist.

Gemäß einer bevorzugten Ausführungsform, die in Fig. 4 gezeigt ist, kann die erfindungsgemäße Auswerteschaltung ferner eine Abschirmung der Verbindungsleitung zwischen Sensor und Verstärker umfassen, wobei die Verstärkungseinrichtung ein Pufferverstärker mit dem Verstärkungsfaktor $V \approx 1$ ($|V-1|N \ll 1$) ist und die Außenleitung der Abschirmung mit dem Ausgang des Pufferverstärkers verbunden ist. Bei dieser Ausführungsform werden weitere, mit den herkömmlichen Verfahren verbundene Probleme beseitigt.

Zum einen liegt bei der in Fig. 10 gezeigten Anordnung die Eingangskapazität des Verstärkers parallel zur Meßkapazität C und führt daher zu einer Verfälschung des Meßergebnisses. Des weiteren tritt allgemein das Problem auf, daß, wenn sich der Sensor nicht in unmittelbarer Nähe des Oszillators oder Verstärkers befindet, in der Regel eine Schirmung der Verbindungsleitung erforderlich ist, um Meßfehler durch wechselnde Umgebungsbedingungen (Streukapazität, Signaleinstreuung) zu vermeiden. Dabei ist die Kapazität $C_K$ des geschirmten Kabels 7, wie in Fig. 11 für den Fall des in Fig. 10 dargestellten Schaltungskonzepts dargestellt, ebenfalls parallel zur Meßkapazität und kann insbesondere bei kleinen Werten für C zu beträchtlichen Meßfehlern führen. Dabei ist insbesondere zu berücksichtigen, daß die Eingangskapazität von Oszillatorschaltungen oder Verstärkern typischerweise zwischen 5 und 10 pF liegt, während die Kabelkapazität ca. 50 bis 100 pF/m beträgt. Die Kabelkapazität ist dabei temperaturabhängig, so daß eine Kompensation des Meßfehlers durch Subtraktion nur für eine Temperatur gilt. Bei Bewegung des Kabels entstehen durch Kapazitätsschwankungen Rauschstörungen.

Gemäß der vorliegenden Ausführungsform wird nun die bei einem geschirmten Kabel zwischen Sensor und Auswerteschaltung auftretende Kabelkapazität durch das Konzept der sogenannten aktiven Schirmung (s. beispielsweise „The Art of Electronics" von P. Horowitz und W. Hil, Cambridge University Press, S. 465) beseitigt. Wie am Beispiel der in Fig. 4 gezeigten Auswerteschaltung wird der Außenleiter des geschirmten Kabels an den Ausgang des Pufferverstärkers mit dem Verstärkungsfaktor $V \approx 1$ angeschlossen. Die wirksame Kapazität des Kabels beträgt dann $C_F = C_K(1-V)$.

Gemäß der vorliegenden Erfindung kann auch, wie zusätzlich in Fig. 4 gezeigt ist, bei allen Ausführungsformen die spannungsgesteuerte Stromquelle 1 durch einen hochohmigen Widerstand $R_B$ ersetzt sein, was für manche Anwendungen, bei denen die Ausgangsspannung nicht exakt proportional zur Impedanz sein muß, eine vom Aufwand her günstige Variante darstellt.

Ein weiteres Problem der bekannten Auswerteschaltungen besteht darin, daß Eingangsströme $I_B$ des Verstärkers oder Leckströme zu einer Stromaufteilung und damit zu einer Verfälschung des Meßwertes für den Realteil R der Impedanz führen, der häufig sehr hochohmig ist, wodurch schon geringe Eingangs- bzw. Leckströme zu Verfälschungen des Meßwertes führen können, die außerdem häufig temperaturabhängig sind, was eine Kompensation sehr erschwert.

Gemäß einer weiteren bevorzugten Ausführungsform, die in Fig. 5 dargestellt ist, kann dieses Problem dadurch gelöst werden, daß die Verstärkungseinrichtung ein Verstärker ist, dessen Anschlüsse für positive Versorgungsspannung und negative Versorgungsspannung einerseits jeweils über einen Vorwiderstand mit der jeweils positiven und negativen Betriebsspannung und andererseits jeweils über eine Zenerdiode mit dem Ausgang der Verstärkungseinrichtung verbunden sind.

Das heißt, wie die Erfinder der vorliegenden Erfindung überraschenderweise feststellten, kann der Einfluß von Leckstrom und Eingangsstrom des Verstärkers sowie dessen wirksame Eingangskapazität beseitigt werden, wenn die Spannungsversorgung des Verstärkers dem aktiven Schirmpotential folgt.

Wie in Fig. 5 gezeigt ist, sind die Anschlüsse für positive Versorgungsspannung Up und negative Versorgungsspannung Un einerseits über Vorwiderstände 8, 9 mit der positiven bzw. negativen Betriebsspannung U+ und U- verbunden und andererseits über Spannungsstabilisatoren wie beispielsweise Zenerdioden 10, 11 mit dem Ausgang des Verstärkers 3. Typische Spannungsverläufe für $U_p$, $U_n$ und $U_{sig}$ sind in Fig. 6 skizziert. In diesem Fall haben Leck- und Eingangsstrom nur einen Gleichspannungsanteil, tragen also nicht zum Wechselspannungssignal bei. Die Eingangskapazität des Verstärkers 3 wird nicht umgeladen, ebenso wie die Kabelkapazität bei aktiver Schirmung, so daß der volle Meßstrom über die Impedanz des Sensors fließt.

Die erfindungsgemäße Vorrichtung zur Messung komplexer Impedanzen umfaßt die Auswerteschaltung zur Ermittlung komplexer Impedanzen wie vorstehend definiert sowie einen oder mehrere Sensoren zur Erfassung der komplexen Impedanz, welche jeweils mindestens zwei Elektroden umfassen können. Dabei können die Elektroden beispielsweise wie in Fig. 8 gezeigt angeordnet sein.

Wenn die erfindungsgemäße Vorrichtung mehrere Sensoren zur Erfassung der komplexen Impedanz umfaßt, ist es in der Regel kostengünstig, nur eine Auswerteschaltung zu verwenden und deren Eingang zwischen den einzelnen Sensoren über einen elektronischen Signalumschalter (sog. Multiplexer) umzuschalten. Die wirksame Eingangkapazität des Multiplexers, die in der gleichen Größenordnung liegt wie die eines Verstärkers, läßt sich ebenfalls dadurch auf Null reduzieren, indem die Versorgungsspannung(en) des Multiplexers ebenfalls dem aktiven Schirmpotential folgen.

Fig. 7 zeigt eine bevorzugte Ausführungsform für drei Sensoren mit den Kapazitäten C1, C2 und C3, wobei alle 3 Sensoren über geschirmte Kabel mit der Auswerteelektronik verbunden sind. Bei der Beschaltung der Steuereingänge des Multiplexers 12 ist zu berücksichtigen, daß diese je nach gewünschter Schalterstellung entweder auf Ub+ oder Ub- liegen müssen, die ja mit dem aktiven Schirmpotential schwanken.

Eine geeignete Beschaltung bei Verwendung von auf negative bzw. positive Betriebsspannung bezogenen Steuersignaleingängen 13, bestehend aus den Vorwiderständen 16, 17, den Transistoren 18, 19 und den Pull-up-Widerständen 14, 15 ist ebenfalls in Fig. 7 gezeigt.

Ein weiteres Problem bei herkömmlichen Vorrichtungen liegt daran, daß die herkömmlich verwendeten kapazitiven Sensoren in hochkorrosiven Flüssigkeiten (hochkonzentrierte Laugen oder Basen) in der Regel nicht über längere Zeit einsetzbar sind, da metallische Elektroden in aller Regel angegriffen bzw. weggeätzt werden.

Dieses Problem kann bei einer bevorzugten Ausführungsform der vorliegenden Erfindung dadurch gelöst werden, daß die komplexe Impedanz mit gegenüber dem zu messenden Medium isolierten Elektroden 28, 29 gemessen wird. Wie die Erfinder der vorliegenden Erfindung feststellten, kann diese Messung mit zuverlässiger Genauigkeit erfolgen, wenn die isolierende Schicht 27 hinreichend dünn ist. Hinreichend dünn heißt in diesem Zusammenhang, daß die Dicke d der isolierenden Schicht dünn ist im Vergleich zum Abstand der Elektroden S, wie in Fig. 8 gezeigt.

Wählt man als isolierende Schicht eine chemisch hochstabile Schicht, so ist ein Schutz der Elektroden auch in hochkorrosiven Medien, wie beispielsweise in hochkonzentrierten Säuren oder Laugen gewährleistet. Gemäß einer bevorzugten Ausführungsform der vorliegenden Erfindung wird Siliziumkarbid in Schichtdicken von 0,1 bis 2 μm verwendet. Es sind jedoch auch andere Materialien für die chemisch hochstabilen Schichten wie beispielsweise $SiO_2$ oder $Si_3N_4$ denkbar.

Gemäß einer weiteren bevorzugten Ausführungsform der vorliegenden Erfindung kann der Multiplizierer 4 auch durch die in Fig. 3 gezeigte Schaltung ersetzt werden. Sie besteht aus zwei mit gegenphasigem Steuersignal angesteuerten Analogschaltern 19, 20, von denen der Analogschalter 20 über das mit dem Verstärker 21 invertierte Meßsignal $U_{sig}$ angesteuert wird. Dieses Schaltungskonzept ist als „phasenempfindlicher Vollwellen-Gleichrichter" bekannt und zeichnet sich durch eine hohe Linearität aus.

Gemäß einer weiteren bevorzugten Ausführungsform der vorliegenden Erfindung kann die beschriebene Vorrichtung zur Messung komplexer Impedanzen auch mit einem Oberflächenwellen (OFW)-Sensor kombiniert werden, wie er beispielsweise aus den deutschen Patentanmeldungen P 196 30 890.9 und P 197 06 486.8 bekannt ist. Bei einer solchen Vorrichtung können dann neben den durch den OFW-Sensor bestimmten Meßgrößen wie beispielsweise Viskosität, Dichte oder Masseanlagerung auch der Leitwert sowie die dielektrischen Eigenschaften bestimmt werden. Dies geschieht dann vorzugsweise durch auf den OFW-Sensor aufgebrachte kapazitative Elektroden.

Gemäß einer bevorzugten Ausführungsform, wie beispielsweise in Fig. 9 gezeigt, kann jedoch auch eine der Interdigitalelektroden 21, 22 auf dem Substrat des OFW-Sensors 20 als kapazitives Meßelektrodenpaar benutzt werden. In diesem Fall erfolgt die elektrische Verbindung zu der Hochfrequenz-Auswerteschaltung 23 des OFW-Sensors, die meistens durch einen Oszillator realisiert ist, mit einem Hochpaß. Die erfindungsgemäße Impedanzauswerteschaltung 26 ist über einen Tiefpaß 25 mit der Interdigitalelektrode verbunden.

**Beispiel:**

Ein Ausführungsbeispiel der vorliegenden Erfindung betrifft ein Sensorsystem mit zwei Sensoren zur Kontrolle des Motoröls und der Bremsflüssigkeit bei Kraftfahrzeugen. Ein solches Sensorsystem läßt sich wie in Fig. 7 gezeigt realisieren. Die Sensoren bestehen dabei jeweils aus auf Quarzglas aufgesputterten Interdigital-Elektroden aus Gold mit einer aktiven Fläche von 1 cm$^2$ und einer Kapazität von 20 pF. Um eine Korrosion der Elektroden zu verhindern, ist ihre Oberfläche mit Siliziumkarbid mit einer Schichtdicke von 1 μm geschützt.

Die Sensoren sind so in einem Kunststoffgehäuse mit Anschlußkabeldurchführung untergebracht und dicht mit beispielsweise Epoxidharz vergossen, daß die Interdigitalstrukturen freibleiben und beim Eintauchen des Sensors in die Flüssigkeit keine Flüssigkeit in den Anschlußbereich des Kabels dringt. Als Anschlußkabel wird ein Koaxial- oder Triaxialkabel, das mit aktiver Schirmung beschaltet ist, verwendet.

Die Sensoren überwachen den Säuregehalt und Wassergehalt des Motoröls und den Wassergehalt der Bremsflüssigkeit. Die Auswertung der Sensorsignale erfolgt in der Regel über einen Microcontroller, der beispielsweise auch den Serviceplan überwacht.

**Patentansprüche**

1.    Auswerteschaltung zur Ermittlung komplexer Impedanzen mit

   -   einer Spannungsquelle (2) zur Erzeugung zweier Wechselspannungssignale mit einer ersten Frequenz;
   -   einer Stromquelle (1) oder einem hochohmigen Widerstand , die oder der von dem ersten von den zwei Wechselspannungssignalen angesteuert wird und geeignet ist, ein Wechselstromsignal zu erzeugen;
   -   einer Verstärkungseinrichtung (3), der das über die zu messende Impedanz (Z) abfallende Signal zugeführt wird und die geeignet ist, ein entsprechende Wechselspannungssignal zu erzeugen;
   -   einer Einrichtung (4), die geeignet ist, das von der Verstärkungseinrichtung ausgegebene Wechselspannungssignal mit dem zweiten von den zwei Wechselspannungssignalen von der Spannungsquelle (2), welches jeweils um 0° oder 90° phasenverschoben ist, dergestalt zu kombinieren, daß aus den sich jeweils ergebenden ersten und zweiten Ausgangssignalen der Realteil und der Imaginärteil der Impedanz ermittelbar ist;
   -   einer Einrichtung zur Verarbeitung des ersten und zweiten Ausgangssignals, wobei der Realteil und der Imaginärteil der komplexen Impedanz ermittelt wird,
**dadurch gekennzeichnet, daß**
die Spannungsquelle (2) einen Frequenzgenerator (8) zur Erzeugung von Digitalsignalen, einen 1:2-Frequenzteiler (9) und eine Vorrichtung (10) zur Erzeugung zweier um 90° phasenverschobener Wechselspannungssignale mit der ersten Frequenz umfaßt, wobei die Phasenverschiebung bei Variation der Frequenz erhalten bleibt.

2.    Auswerteschaltung nach Anspruch 1, **dadurch gekennzeichnet, daß** der Frequenzgenerator (8) geeignet ist, ein Signal mit dem zweifachen der ersten Frequenz und einem Tastverhältnis von 50 % zu erzeugen.

3.    Auswerteschaltung nach Anspruch 1, **dadurch gekennzeichnet, daß** der Frequenzgenerator (8) geeignet ist, ein Signal mit dem vierfachen der ersten Frequenz zu erzeugen, und die Spannungsquelle ferner einen zweiten 1:2-Frequenzteiler umfaßt.

4.    Auswerteschaltung nach einem der vorhergehenden Ansprüche **dadurch gekennzeichnet, daß** die Vorrichtung (10) zur Erzeugung zweier um 90° phasenverschobener Wechselspannungssignale mit der ersten Frequenz ein D-Flip-Flop ist.

5.    Auswerteschaltung nach einem der Ansprüche 1 bis 4, **dadurch gekennzeichnet, daß** die Einrichtung (4), die geeignet ist, das von der Verstärkungseinrichtung ausgegebene Wechselspannungssignal mit dem zweiten von den zwei Wechselspannungssignalen von der Spannungsquelle, welches jeweils um 0° oder 90° phasenverschoben ist, dergestalt zu kombinieren, daß aus den sich jeweils ergebenden ersten und zweiten Ausgangssignalen der Realteil und der Imaginärteil der Impedanz ermittelbar ist, ein Multiplizierer oder ein Mischer ist.

6.    Auswerteschaltung nach einem der Ansprüche 1 bis 4, **dadurch gekennzeichnet, daß** die Einrichtung (4), die geeignet ist, das von der Verstärkungseinrichtung ausgegebene Wechselspannungssignal mit dem zweiten von den zwei Wechselspannungssignalen von der Spannungsquelle, welches jeweils um 0° oder 90° phasenverschoben ist, dergestalt zu kombinieren, daß aus den sich jeweils ergebenden ersten und zweiten Ausgangssignalen der Realteil und der Imaginärteil der Impedanz ermittelbar ist, ein phasenempfindlicher Halb- oder Vollwellen-Gleichrichter ist.

7.    Auswerteschaltung nach einem der vorhergehenden Ansprüche, **weiter gekennzeichnet durch** ein vor der Stromquelle (1) angeordnetes Tiefpaßfilter.

8. Auswerteschaltung nach einem der vorhergehenden Ansprüche, **gekennzeichnet durch** eine Abschirmung (7) der Verbindungsleitung zwischen Sensor (Z) und Verstärkungseinrichtung (3), wobei die Verstärkungseinrichtung ein Pufferverstärker mit dem Verstärkungsfaktor V ≈ 1 ist und die Außenleitung der Abschirmung mit dem Ausgang des Pufferverstärkers verbunden ist.

9. Auswerteschaltung nach einem der Ansprüche 1 bis 7, **dadurch gekennzeichnet, daß** die Verstärkungseinrichtung (3) ein Verstärker ist, dessen Anschlüsse für positive Versorgungsspannung und negative Versorgungsspannung einerseits jeweils über einen Vorwiderstand (8, 9) mit der jeweils positiven und negativen Betriebsspannung und andererseits jeweils über eine Einrichtung zur Spannungsstabilisierung (10, 11) mit dem Ausgang der Verstärkungseinrichtung (3) verbunden sind.

10. Vorrichtung zur Messung komplexer Impedanzen, **gekennzeichnet durch** einen oder mehrere Sensoren mit jeweils zwei Elektroden (28, 29) zur Erfassung der komplexen Impedanz, und eine Auswerteschaltung nach einem der Ansprüche 1 bis 9.

11. Vorrichtung nach Anspruch 10 mit mehreren Sensoren, **gekennzeichnet durch** einen Signalumschalter (12), der geeignet ist, den Eingang der Auswerteschaltung zwischen den einzelnen Sensoren umzuschalten.

12. Vorrichtung nach Anspruch 10 oder 11, **dadurch gekennzeichnet, daß** die Elektroden (28, 29) mit einer im Vergleich zum Abstand der Elektroden voneinander dünnen Isolierschicht (27) überzogen sind.

13. Vorrichtung nach Anspruch 12, **dadurch gekennzeichnet, daß** die Isolierschicht (27) chemisch hochstabil ist.

14. Vorrichtung nach Anspruch 13, **dadurch gekennzeichnet, daß** die Isolierschicht (27) aus Siliziumkarbid besteht.

15. Vorrichtung nach einem der Ansprüche 12 bis 14, **dadurch gekennzeichnet, daß** die Dicke der Isolierschicht (27) 0,2 bis 2 μm beträgt.

16. Vorrichtung nach einem der Ansprüche 10 bis 15, **dadurch gekennzeichnet, daß** der Sensor ein Oberflächenwellensensor mit darauf aufgebrachten kapazitativen Elektroden ist und die Vorrichtung Einrichtungen zur Ermittlung weiterer Meßgrößen umfaßt.

17. Vorrichtung nach einem der Ansprüche 10 bis 15, **dadurch gekennzeichnet, daß** der Sensor (20) ein Oberflächenwellensensor mit Interdigitalelektroden (21, 22) auf dem Substrat des Oberflächenwellensensors ist, wobei eine (21) der Interdigitalelektroden ein Meßelektrodenpaar bereitstellt, und die Vorrichtung Einrichtungen (23) zur Ermittlung weiterer Meßgrößen umfaßt.

18. Verwendung der Vorrichtung nach einem der Ansprüche 10 bis 17 zur Analyse der Eigenschaften von Flüssigkeiten.

19. Verwendung der Vorrichtung nach einem der Ansprüche 10 bis 17 zur Bestimmung des Alterungszustands von Schmierölen.

20. Verwendung der Vorrichtung nach einem der Ansprüche 10 bis 17 zur Feuchtemessung in Erdböden.

21. Verwendung der Vorrichtung nach einem der Ansprüche 10 bis 17 zur Messung von Ionenkonzentrationen.

22. Verwendung der Vorrichtung nach einem der Ansprüche 10 bis 17 zur Bestimmung des Wassergehalts in Flüssigkeiten mit niedriger Dielektrizitätszahl.

23. Verwendung der Vorrichtung nach einem der Ansprüche 10 bis 17 zur Bestimmung der Wasserkonzentration in Alkoholen und umgekehrt.

24. Verwendung der Vorrichtung nach einem der Ansprüche 10 bis 17 zur Bestimmung des Wassergehalts in Ölen und umgekehrt.

25. Verwendung der Vorrichtung nach einem der Ansprüche 10 bis 17 zur Bestimmung des Wassergehalts in Bremsflüssigkeit.

26. Verwendung der Vorrichtung nach einem der Ansprüche 10 bis 17 zur Bestimmung der Zusammensetzung von Milch.

27. Verwendung der Vorrichtung nach einem der Ansprüche 10 bis 17 zur Bestimmung des Zeitpunkts der Aushärtung von Beton.

28. Verwendung der Vorrichtung nach einem der Ansprüche 10 bis 17 zur Bestimmung der Verunreinigung des Erdbodens mit Öl oder Säuren.

29. Verwendung der Vorrichtung nach Anspruch 16 oder 17 zur Identifikation von Säuren und Laugen in Wasser und zur Bestimmung ihrer Konzentration.

**FIG. 1**

**FIG. 2**

Zeit

**FIG. 3**

**FIG. 4**

**FIG. 5**

**FIG. 6**

**FIG. 8**

FIG. 7

FIG. 9

FIG. 10

FIG. 11